# EUROPEAN PATENT SPECIFICATION

(11) **EP 1 099 002 B1**
(45) Date of publication and mention of the grant of the patent: **08.05.2002**
(21) Application number: 99955302.7
(22) Date of filing: 04.06.1999
(51) Int. Cl.: C23C 14/00, C23C 14/30

(54) **COMPOSITION FOR PRODUCTION OF A PROTECTIVE GRADIENT COATING ON A METAL SUBSTRATE BY ELECTRON BEAM EVAPORATION AND CONDENSATION UNDER VACUUM**
ZUSAMMENSETZUNG ZUR HERSTELLUNG EINER GRADIENTENSCHUTZBESCHICHTUNG AUF EIN METALLSUBSTRAT DURCH ELEKTRONENSTRAHLVERDAMPFUNG UND KONDENSATION UNTER VAKUUM
COMPOSITION PERMETTANT DE PRODUIRE UN REVETEMENT A GRADIENT DE PROTECTION SUR UN SUBSTRAT METALLIQUE PAR EVAPORATION PAR FAISCEAU D'ELECTRONS ET PAR CONDENSATION SOUS VIDE

(30) Priority: 04.06.1998 UA 98062916
(43) Date of publication of application: 16.05.2001
(73) Proprietor: UNITED TECHNOLOGIES CORPORATION, Hartford, CT 06101 (US); International Center for Electron Beam Technologies of E.O. Paton Electric Welding Institute, Kiev 252005 (UA)
(72) Inventor: MOVCHAN, Marina B., Kiev, 252004 (UA); KORZH, Alexander V., Kiev, 252033 (UA); RUDOY, Jury E., Kiev, 252167 (UA)
(74) Representative: Leckey, David Herbert
(86) International application number: UA9900010
(87) International publication number: WO9963127

(56) References cited:
- EP-A- 0 799 904
- DATABASE WPI Section Ch, Week 198440 Derwent Publications Ltd., London, GB; Class M13, AN 1984-249373 XP002900732 & SU 1 073 327 A (BELORUSSIAN POLY), 15 February 1984 (1984-02-15)

## Description

### Field of the invention

The invention relates to the field of electron beam technology of producing on a metal substrate the functionally-gradient protective coatings with the outer ceramic or metal-ceramic layer by evaporation and subsequent condensation with moderate substrate temperatures (300 to 500°C) of mixtures of metals, alloys and oxides having different melting temperature and vapour pressure at the evaporation temperature. In particular, the invention relates to the field of protective coatings on parts of titanium alloys used in gas turbines, and more specifically to a composition for production of a protective gradient coating on a metal substrate.

### Prior art

It is known that a weak link in the substrate/coating system is the flat interface between them. The difference in the physico-mechanical properties of the substrate and the coating, primarily of the thermal factors of linear expansion and the Young's modulus, as well as the irreversible reactions, for instance, oxidation, on the interface during operation, lead to premature failure of the coating and deterioration of the item performance.

In this connection over the last 5 to 10 years, the coatings were perfected by development of a certain (functional) gradient of the composition and structure in the direction from the substrate to the coating upper layers. This problem is especially urgent for protective coatings with the external ceramic layer of oxide ceramics deposited onto metal surfaces.

By now a new direction of material science has already formed in the field of protective coatings,namely the functionally gradient protective coatings (MRS Bulletin v.20, No.1, 1995). This area is based primarily on up-to-date technologies of air plasma spraying (APS), vacuum-plasma spraying (VPS, LPPS) and electron beam vapour deposition of coatings under vacuum (EB-PVD). Used here are both spraying of individual coating components from several sources and of complex compositions which predetermine the protective coating composition, from one source.

For instance, in the US patent No. 4,248,940 of 03.02.81 (G.Goward, et al), the gradient coating with the external ceramic layer of ZrO₂ - Y₂O₃ and ZrO₂ - MgO oxide ceramics is produced with two independent sources of air plasma by spraying by a certain program a powder of the high-temperature alloy (15-40)%Cr-(10-15)%Al-(0.01-1.0)%Y, the balance being Ni-Co alloy and the powder of the above ceramics.

Also known are the NiCr|(ZrO₂-8%Y₂O₃) and Ni|Al₂O₃ gradient coatings produced with LLPS by spraying from one source of compositions of a mixture of powders with an increasing content of ceramics (S.Sampath et al., MRS Bulletin, v.20, No.1(1995), p.27-31).

A similar approach, but using APS, is also applied in production of protective gradient NiCrCoAlY|ZrO₂ coating on Ti-6Al-4V titanium alloy (Xiang Xinhua et al., Surface and Coatings Technology, v.88, (1996), p.66-69).

Electron beam technology (EP-PVD) is applied for production of gradient bond coats of NiCoCrAlY type on nickel alloys. The change of concentration of some elements across the bond coat thickness was achieved by variation of the process parameters of evaporation and condensation (U.Shulz et al., Third International Symposium on Structural and Functional Gradient Materials, ed. B.Ilschner and N.Cherrardi (Lausanne, Switzerland) Press Polytechniques et Universitaires Romandes, (1994), p.441-446).

Development of functionally gradient compositions and structures across the thickness of protective coatings is a mandatory, but insufficient condition for production of highly reliable substrate - coating combinations. A certain gradient transition zone is required between the substrate and the functionally gradient coating, which provides a high strength of the coating adhesion to the substrate. In the above process variants this zone is created by stimulating the diffusion processes in the contact zone, either in deposition of coatings at the expense of preliminary high-temperature heating of the substrate (item), or through a high-temperature annealing of the item after the coating deposition, or by a successive use of the first and the second thermal actions. For instance, for nickel-base alloys the range of temperatures of pre-heating and annealing is equal to 900 to 1100°C.

High-temperature heating and annealing are not only additional process operations, but also a sort of barrier limiting the range of materials and articles onto which protective coatings can be deposited by the above methods. These limitations are related to the possible change of the item material structure and of the shape of the items proper at high-temperature heating and long-term annealing. Also noted should be the possibility of considerable internal stresses developing in the coatings after high-temperature annealing and subsequent cooling of the items to room temperature.

In connection with the above-said, further improvement of the functionally gradient protective coatings can be performed in the direction of creation of coatings deposited at room temperatures with a simultaneous formation between the substrate and the functionally gradient coating of the above gradient transition zone which provides a high strength of the coating adhesion to the substrate without the need for applying subsequent high-temperature annealing.

However, in production of a protective gradient coating with the external ceramic layer on a metal substrate by electron beam evaporation and condensation under vacuum, such a task can be solved by applying a special composition made up by a mixture of metals, alloys and oxides having different temperatures of melting and vapour pressures at the evaporation temperature.

The closest prior art for this invention and therefore taken is EP application No. 97105545.4 of 03.04.97, publication EP 0799904 A1, MPK⁶ S23S 14/30, 14/06, 14/02, Bulletin 1997/41, 08.10.1997 (B.Movchan et al.). Better properties are demonstrated by the composition proposed in one of the embodiments of the invention of the above application for production of a protective gradient coating on a metal substrate by electron beam evaporation and condensation under vacuum based on a mixture of metals and metal oxides having different vapour pressures at the evaporation temperature, namely (% per mass) Al 5-40, A₂O₃ 60, ZrO₂ being the balance. Aluminium having a low melting temperature and the highest vapour pressure at the evaporation temperature, is added to the above mixture. The above mixture in the form of a compacted and annealed under vacuum tablet placed on top of a ceramic ingot or into a copper water-cooled crucible, is melted by the electron beam. The vapour pressure of the tablet components at the evaporation temperature is maximal for aluminium and minimal for zirconium oxide, i.e. it is reduced in the following sequence Al - > Al₂O₃ -> ZrO₂. Therefore, aluminium is the first to start evaporating, then aluminium oxide evaporation begins and zirconium oxide evaporates at the final stage. As a result, a gradient of component concentrations across the coating thickness is created during condensation. The first portions of aluminium while condensing on a preheated substrate, interact with the surface layers of the substrate and actively participate in formation of the composition and structure of the substrate - coating contact zone.

The above composition provides good physico-mechanical characteristics of the coating in a broad range of working conditions in the case when the temperature of the substrates preheating during the above coating deposition, is 900 to 1050°C. This temperature does not create undesirable changes of the structure or stresses in nickel alloys for which the coating proposed in the prototype, is designed.

For a number of other alloys, however, in particular, those based on Ti, Cu or Fe. such temperatures are too high.

Therefore, still urgent is the problem of creation of compositions suitable for production of protective functionally gradient coatings by electron beam evaporation and condensation under vacuum on metal substrates preheated up to moderate temperatures (300 to 500°C), in particular on metal substrates of titanium-, copper- or iron-based alloys.

### Summary of the invention

The invention proceeds from the task of creation of a composition suitable for deposition of a protective gradient coating onto a metal substrate by electron beam vapour evaporation and condensation under vacuum at moderate (300 - 500°C) temperatures of the substrate surface, which, though appropriate selection of its components, would ensure the formation of a transition zone between the substrate and the functionally gradient coating, providing a high strength of adhesion of the coating to the substrate and its high hardness.

The above task is solved by proposing a composition for production by electron beam evaporation and condensation under vacuum, of a protective gradient coating on a metal substrate, based on a mixture of metals and metal oxides having different vapour pressure at the evaporation temperature, which, according to the invention, consists of Sn and Cr as metals, and chromium oxide and aluminium oxide as metal oxides with the following ratio of the components (% per mass):
Sn - 1 - 13
Cr - 1-40
Cr₂O₃-0.1- 10
Al₂O₃ - balance.

The method of deposition of the above composition by electron beam evaporation and condensation under vacuum is described, for instance, in RU patent No.2120494.

It is this formulation of the composition which allows its deposition at moderate (300 to 500°C) temperatures and production of a coating with a high adhesion strength and hardness.

Adding into the composition Sn as a low-melting component with the melting temperature of 232°C and with the maximal vapour pressure at the evaporation temperature provides at the initial stage of condensation the formation of a thin liquid film of Sn, which interacts with the surface layers of the substrate and determines the composition and structure of the transition zone of contact.

At the temperature of 300 to 500°C Sn has a considerable solubility in Ti (about 20 % per mass), Fe (about 10 % per mass) and Cu (about 10 % per mass) and alloys on their base. Therefore, if the substrate is made of such metals and alloys, the above liquid film wets the substrate surface, smoothing the roughnesses of this surface and, dissolving in the substrate material, does not form any brittle phases undesirable in terms of the coating adhesion to the substrate.

In further evaporation of the composition according to the invention, a Cr-Cr₂O₃-Al₂O₃ metal-ceramic coating is formed on top of the transition zone enriched in Sn, the coating having a whole set of mechanical and physico-mechanical properties attractive in terms of protective coatings, namely high hardness, coefficient of linear thermal expansion close to that of metal alloys, excellent oxidation resistance, good high temperature resistance, etc.

The above task is also solved by proposing a composition for production by electron beam evaporation and condensation under vacuum, of a protective gradient coating on a metal substrate, based on a mixture of metals and metal oxides having different vapour pressure at the evaporation temperature, which, according to the invention, consists of Sn, Al and Cr as metals, and chromium oxide and aluminium oxide as metal oxides with the following ratio of the components (% per mass):
Sn-1-13
Al-1-8
Cr - 1-40
Cr₂O₃ - 0.1 - 10
Al₂O₃ - balance.

This is owing to the fact that Al, as well as Sn, has a considerable solubility in Ti, Fe and Cu, the above composition provides an increase in the adhesion strength of the coating.

The above task is also solved by proposing a composition for production by electron beam evaporation and condensation under vacuum, of a protective gradient coating on a metal substrate, based on a mixture of metals and metal oxides having different vapour pressure at the evaporation temperature, which, according to the invention, consists of Sn, Al and Cr as metals, and chromium oxide, magnesium oxide and aluminium oxide as metal oxides with the following ratio of the components (% per mass):
Sn - 1 - 13
Al - 1 - 8
Cr-1-40
Cr₂O₃ - 0.1 - 10
MgO - 30 - 50
Al₂O₃ - balance.

It is known (Cermets, Ed. J.R. Tinklepaugh and W.RCrandall, 1960, Reinhold Publishing Corporation), that MgO addition, similar to Cr₂O₃ addition, to Al₂O₃-Cr cermets increases their density and hardness.

The composition according to the invention, produced by any metallurgical process, in particular, by mixing and pressing of powders, provides good physical and technological properties of the coatings produced by the method of electron beam evaporation and deposition under vacuum onto a substrate preheated up to 300 to 500°C, high strength of the coating adhesion to the substrate and high hardness of the coating.

### Brief description of the drawings

The technical essence and principle of the invention is clarified by the examples of its embodiment with reference to the appended drawings, where:
Fig. 1 shows the scheme of placing the composition in the form of a tablet in a water-cooled crucible;
Fig. 2 shows the distribution of Sn, Cr, All and O across the thickness of the gradient coating produced by evaporation of the following composition (% per mass) 13%Sn - 13%Cr - 0.5%Cr₂O₃ - 73.5%Al₂O₃.

### A detailed description of the invention

The proposed composition for production on the metal substrate of a protective functionally gradient coating deposited by the method of electron beam evaporation and condensation under vacuum, is a mixture of metal powders and oxides having different vapour pressure at the evaporation temperature, in the following basic concentration (% per mass):
Sn - 1 - 13
Cr - 1 - 40
Cr₂O₃ - 0.1 - 10
Al₂O₃ - balance.

Presence of Sn in the composition, being a low-melting component which is the first to evaporate and, while condensing, acts as the "adhesive", first smoothing the microrelief of the surface, and then participating in formation of the composition and structure of the substrate/coating transition zone, lowers the requirements to the roughness of the sample surface. It is experimentally found that for deposition of the coating using the proposed composition, sufficient is the sandblasting which creates a relief of about 1 µm depth.

The advantages of the proposed composition, compared to the known ones, are illustrated in the following examples.

### Example 1.

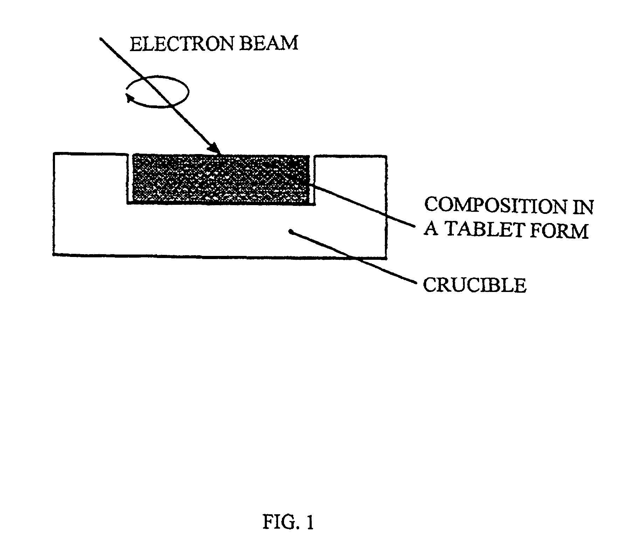

A mixture of the composition components in the basic concentration (% per mass) : 13%Sn, 13%Cr, 0.5%Cr₂O₃, 73.5%Al₂O₃, compressed from powders into a tablet of 25 mm diameter and 6 g weight, was placed into a water-cooled crucible (Fig. 1), and electron beam evaporation was performed with subsequent condensation on 70 x 5 x 2.5 mm flat samples of low-carbon steel, copper and titanium at the temperature of 300 °C under vacuum at the beam power of 26 to 28 kW and the beam current of about 1.5 A. At the distance from the source to the condensation surface of 320 to 340 mm, the thickness of the gradient coating on a stationary substrate was 5 µm. The coating thickness is proportional to the tablet weight. For coatings of 6 to 7 µm thickness, sufficient is the tablet weight of 8 to 10 g.

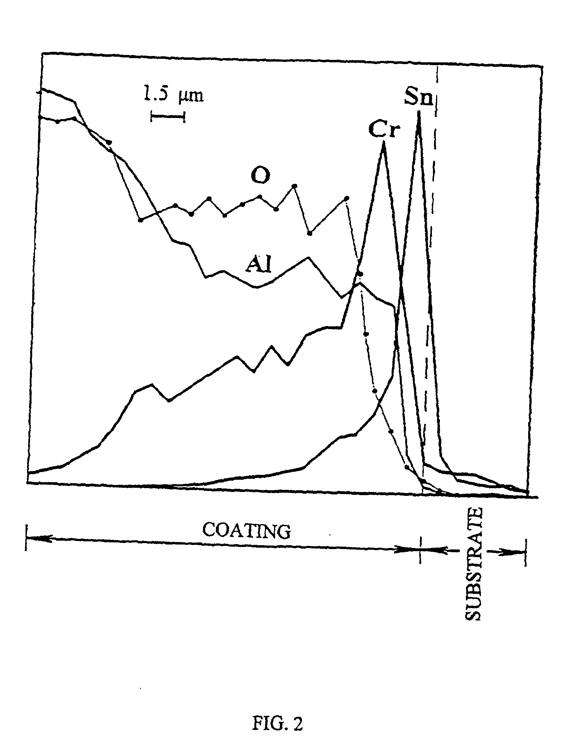

Concentration of Sn in the substrate/coating contact zone is also proportional to the content of Sn in the tablet. Fig. 2 shows the distribution of Sn and other elements in the contact zone and in the coating produced in evaporation of a tablet of the following composition (by weight): 13%Sn - 13%Cr - 0.5%Cr₂O₃ - 73.5%Al₂O₃, of 40 g weight.

The strength of the coating adhesion to the substrate and the coating quality were determined by the angle of bending of a coated sample before the start of delamination or failure of the coating. The angle of bend of the above flat samples of low-carbon steel, copper and titanium was determined by a three-point bending procedure with 18 mm spacing of the supports and 1 mm/min loading rate. Its value was about 90°. Microhardness Hᵥ of the coating surface was determined at 50 g load. Its value was 8 to 9 GPa.

### Example 2.

Under conditions identical to the conditions of example 1, electron beam evaporation was performed with subsequent condensation onto 70 x 5 x 2.5 mm flat samples of low-carbon steel, copper and titanium, of the following composition (% per mass): 6Sn - 3Al - 15Cr - 0.5Cr₂O₃ - 75.5Al₂O₃. The thickness of the gradient coating on a stationary substrate was approximately 6 µm.

The strength of adhesion of the coating to the substrate and the coating quality were determined as in example 1, by the angle of bend of the coated sample before the start of delamination or fracture of the coating. In this case the value of the angle of bend was approximately 120°. Microhardness Hᵥ of the coating surface at 50 g load was equal to 8 to 9 GPa.

### Example 3.

Under conditions identical to the conditions of example 1 electron beam evaporation was performed with subsequent condensation onto 70 x 5 x 2.5 mm flat samples of low-carbon steel, copper and titanium, of the following composition (% per mass): 6Sn - 2Al - 34Cr - 1Cr₂O₃ - 44MgO - 13Al₂O₃. The thickness of the gradient coating on a stationary substrate was approximately 6 µm.

The strength of adhesion of the coating to the substrate and the coating quality were determined, as in example 1, by the angle of bending of the coated sample before the start of delamination or fracture of the coating. And in this case the value of the angle of bend was approximately 90° - 100°.

Microhardness Hᵥ of the coating surface was determined at 50 g load. Its value was 19 to 20 GPa.

This invention will find application in industry in deposition of the protective functionally gradient coatings on the articles of iron and copper alloys and especially in the field of formation of protective coatings on parts of titanium alloys used in gas turbines.

## Claims

1. A composition for production of a protective gradient coating on a metal substrate by electron beam evaporation and condensation under vacuum, based on a mixture of metals and metal oxides having different vapour pressure at the evaporation temperature, **characterized in that** the composition consists of Sn and Cr as metals, and chromium oxide and aluminium oxide as metal oxides, with the following ratio of the components (% per mass):
Sn - 1 - 13
Cr - 1 - 40
Cr₂O₃ - 0.1 - 10
Al₂O₃ - balance

2. A composition for production of a protective gradient coating on a metal substrate by electron beam evaporation and condensation under vacuum, based on a mixture of metals and metal oxides having different vapour pressure at the evaporation temperature, **characterized in that** the composition consists of Sn, Al and Cr as metals, and chromium oxide and aluminium oxide as metal oxides, with the following ratio of the components (% per mass):
Sn-1-13
Al-1-8
Cr-1-40
Cr₂O₃ - 0.1 -10
Al₂O₃ - balance

3. A composition for production of a protective gradient coating on a metal substrate by electron beam evaporation and condensation under vacuum, based on a mixture of metals and metal oxides having different vapour pressure at the evaporation temperature, **characterized in that** the composition consists of Sn, Al and Cr as metals, and chromium oxide, magnesium oxide and aluminium oxide as metal oxides, with the following ratio of the components (% per mass):
Sn - 1 - 13
Al - 1 - 8
Cr - 1 - 40
Cr₂O₃ - 0.1 - 10
MgO - 30 - 50
Al₂O₃ - balance

4. A method for producing a protective gradient coating on a metal substrate that includes performing electron beam evaporation of a composition as claimed in any one of claims 1 to 3 and subsequent condensation under vacuum onto said metal substrate.

5. A metal substrate having a protective gradient coating produced by a method as claimed in claim 4.

## Patentansprüche

1. Zusammensetzung zur Herstellung einer Gradienten-Schutzbeschichtung auf einem Metallsubstrat durch Elektronenstrahl-Verdampfung und Kondensation unter Vakuum, auf der Basis eines Gemisches von Metallen und Metalloxiden mit verschiedenem Dampfdruck bei der Verdampfungstemperatur,
**dadurch gekennzeichnet,**
**dass** die Zusammensetzung aus Sn und Cr als Metalle und aus Chromoxid und Aluminiumoxid als Metalloxide, mit dem folgenden Verhältnis der Bestandteile (Masseprozent), besteht:
Sn - 1 - 13
Cr -1 - 40
Cr₂O₃ - 0,1 -10
Al₂ O₃ - Rest

2. Zusammensetzung zur Herstellung einer Gradienten-Schutzbeschichtung auf einem Metallsubstrat durch Elektronenstrahl-Verdampfung und Kondensation unter Vakuum, auf der Basis eines Gemisches von Metallen und Metalloxiden mit verschiedenem Dampfdruck bei der Verdampfungstemperatur,
**dadurch gekennzeichnet,**
**dass** die Zusammensetzung aus Sn, Al und Cr als Metalle und aus Chromoxid und Aluminiumoxid als Metalloxide, mit dem folgenden Verhältnis der Bestandteile (Masseprozent), besteht:
Sn-1-13
AI - 1 - 8
Cr- 1-40
Cr₂O₃ - 0,1 - 10
Al₂ O₃ - Rest

3. Zusammensetzung zur Herstellung einer Gradienten-Schutzbeschichtung auf einem Metallsubstrat durch Elektronenstrahl-Verdampfung und Kondensation unter Vakuum, auf der Basis eines Gemisches von Metallen und Metalloxiden mit verschiedenem Dampfdruck bei der Verdampfungstemperatur,
**dadurch gekennzeichnet,**
**dass** die Zusammensetzung aus Sn, Al und Cr als Metalle und aus Chromoxid, Magnesiumoxid und Aluminiumoxid als Metalloxide, mit dem folgenden Verhältnis der Bestandteile (Masseprozent), besteht:
Sn-1-13
AI - 1 - 8
Cr- 1-40
Cr₂O₃ - 0,1 -10
MgO - 30 - 50
Al₂ O₃ - Rest

4. Verfahren zur Herstellung einer Gradienten-Schutzbeschichtung auf einem Metallsubstrat, das die Durchführung einer Elektronenstrahl-Verdampfung einer Zusammensetzung, wie sie in einem der Ansprüche 1 bis 3 beansprucht ist, und die nachfolgende Kondensation unter Vakuum auf dem Metallsubstrat beinhaltet.

5. Metallsubstrat mit einer Gradienten-Schutzbeschichtung, die nach einem Verfahren gemäß Anspruch 4 hergestellt wurde.

## Revendications

1. Composition pour la production d'un revêtement à gradient de protection sur un substrat métallique, par évaporation par faisceau d'électrons et condensation sous vide, à base d'un mélange de métaux et d'oxydes métalliques ayant différentes pressions de vapeur à la température d'évaporation, **caractérisée en ce que** la composition est constituée de Sn et de Cr à titre de métaux, et d'oxyde de chrome et d'oxyde d'aluminium à titre d'oxydes métalliques, avec les proportions suivantes des composants (% en masse):
Sn 1 à 13
Cr 1 à 40
Cr₂O₃ 0,1 à 10
Al₂O₃ le reste

2. Composition pour la production d'un revêtement à gradient de protection sur un substrat métallique, par évaporation par faisceau d'électrons et condensation sous vide, à base d'un mélange de métaux et d'oxydes métalliques ayant différentes pressions de vapeur à la température d'évaporation, **caractérisée en ce que** la composition est constituée de Sn, de Al et de Cr à titre de métaux, et d'oxyde de chrome et d'oxyde d'aluminium à titre d'oxydes métalliques, avec les proportions suivantes des composants (% en masse):
Sn 1 à 13
Al 1 à 8
Cr 1 à 40
Cr₂O₃ 0,1 à 10
Al₂O₃ le reste

3. Composition pour la production d'un revêtement à gradient de protection sur un substrat métallique, par évaporation par faisceau d'électrons et condensation sous vide, à base d'un mélange de métaux et d'oxydes métalliques ayant différentes pressions de vapeur à la température d'évaporation, **caractérisée en ce que** la composition est constituée de Sn, de Al et de Cr à titre de métaux, et d'oxyde de chrome, d'oxyde de magnésium et d'oxyde d'aluminium à titre d'oxydes métalliques, avec les proportions suivantes des composants (% en masse):
Sn 1 à 13
Al 1 à 8
Cr 1 à 40
Cr₂O₃ 0,1 à 10
MgO 30 à 50
Al₂O₃ le reste

4. Procédé pour produire un revêtement à gradient de protection sur un substrat métallique, qui comprend la réalisation d'une évaporation par faisceau d'électrons d'une composition telle que revendiquée dans l'une quelconque des revendications 1 à 3 et d'une condensation sous vide subséquente sur ledit substrat métallique.

5. Substrat métallique ayant un revêtement à gradient de protection produit par un procédé tel que revendiqué dans la revendication 4.
